# EUROPEAN PATENT SPECIFICATION

(11) **EP 3 909 711 B1**
(45) Date of publication and mention of the grant of the patent: **26.03.2025**
(21) Application number: 19909142.2
(22) Date of filing: 19.12.2019
(51) Int. Cl.: B23K 1/00, B23K 1/19, B23K 33/00, F28D 15/02, F28F 13/00, F28F 21/08, H01L 23/367, H01L 23/427

(54) **HEAT PIPE STRUCTURE, HEAT SINK, METHOD FOR PRODUCING HEAT PIPE STRUCTURE, AND METHOD FOR PRODUCING HEAT SINK**
WÄRMEROHRSTRUKTUR, KÜHLKÖRPER, VERFAHREN ZUR HERSTELLUNG EINER WÄRMEROHRSTRUKTUR UND VERFAHREN ZUR HERSTELLUNG EINES KÜHLKÖRPERS
STRUCTURE DE TUBE CALOPORTEUR, DISSIPATEUR THERMIQUE, PROCÉDÉ DE PRODUCTION D'UNE STRUCTURE DE TUBE CALOPORTEUR ET PROCÉDÉ DE PRODUCTION D'UN DISSIPATEUR THERMIQUE

(30) Priority: 09.01.2019 JP 2019002193
(43) Date of publication of application: 17.11.2021
(73) Proprietor: FURUKAWA ELECTRIC CO., LTD., Chiyoda-ku Tokyo 100-8322 (JP)
(72) Inventor: SASAKI, Chiyoshi, Tokyo 100-8322 (JP); ISEMURA, Masakazu, Tokyo 100-8322 (JP)
(74) Representative: Zacco GmbH
(86) International application number: PCT/JP2019/049731
(87) International publication number: WO 2020/145066

(56) References cited:
- EP-A1- 3 088 829
- DE-A1- 102006 052 753
- JP-A- 2001 248 982
- JP-A- 2006 308 240
- JP-A- 2006 322 665
- JP-A- 2007 218 439
- JP-A- 2009 142 890
- JP-A- 2011 169 506
- JP-A- 2015 227 768
- JP-A- H07 147 358
- JP-A- H1 079 586
- JP-A- H11 300 436
- US-A- 5 826 645
- US-A1- 2003 102 108
- US-A1- 2007 151 711
- US-B1- 7 036 566

## Description

### Technical Field

The present invention relates to a heat pipe structure including a heat pipe, which is a heat transport member in which working fluid is encapsulated on an inside of a decompressed container part, and a base block to which the heat pipe is thermally connected, a heat sink in which a heat radiation fin is provided in the heat pipe of the heat pipe structure, a manufacturing method for the heat pipe structure, and a manufacturing method for the heat sink.

### Background Art

As a cooling device used for cooling of control equipment or the like in which a semiconductor element is used, there has been known a cooling device that cools a heat generating body using latent heat at the time when working fluid boils. This cooling device includes, for example, a base block thermally connected to the heat generating body and a heat pipe thermally connected to the base block. The heat pipe is a heat transport member. A container part of the heat pipe is a sealed container and an inside of the container part is subjected to decompression treatment. The working fluid is encapsulated on the inside of the container part. The heat pipe transports heat received from the heat generating body, which is a cooling target, via the base block using latent heat due to a phase change of this working fluid.

When the heat pipe is thermally connected to the base block, in order to give heat transferability from the base block to the heat pipe and fixing stability of the heat pipe to the base block, it is requested to surely fix the heat pipe to the base block while reducing an air gap of a connecting part of the base block and the heat pipe.

As means for thermally connecting the heat pipe to the base block, there are, for example, a connecting method by caulking for accommodating the heat pipe in a heat pipe accommodating part including a recessed part formed in the base block and a pair of wall parts projecting from the recessed part, caulking the pair of wall parts, and thermally connecting the heat pipe to the base block and a connecting method by soldering for accommodating the heat pipe in the recessed part formed in the base block and soldering the heat pipe to the recessed part.

The connecting method by soldering easily reduces the air gap of the connecting part of the base block and the heat pipe. Therefore, the connecting method by soldering is excellent in the heat transferability from the base block to the heat pipe. The heat pipe can be surely fixed to the base block. However, depending on a material of the base block and a material of the heat pipe, in order to connect the heat pipe to the base block, it is necessary to sometimes form a plating film on the base block in advance before the soldering. **In** the connecting method by soldering, it is necessary to prepare a predetermined amount of solder in a joining part and melt the solder to join the base block and the heat pipe. Therefore, operation is complicated and cost is high. Accordingly, depending on conditions of use and the like of the heat pipe structure, the connecting method by caulking in which it is unnecessary to form an expensive plating film on the base block and joining operation for the base block and the heat pipe is easy is adopted.

As a heat pipe structure in which the heat pipe is thermally connected to the base block by caulking means, for example, there has been proposed a heat pipe structure including a heat pipe, a flat block made of metal, an attachment groove part formed along a surface direction on one surface side of the flat block, one end portion of the heat pipe disposed in the attachment groove part, and a protruding part relatively formed by recessing a vicinity of the attachment groove part in the flat block in a thickness direction, the protruding part being a claw part for fixing bent to an inner side of the attachment groove part and engaged with the one end portion of the heat pipe (Patent Literature 1).

Further a heat pipe structure according to the preamble of claim 1 is known from Patent Literature 2.

On the other hand, fine unevenness caused, for example, when the recessed part is formed is present on a recessed part inner surface of the base block in which the heat pipe is accommodated. Because of dimension accuracy of the heat pipe and the recessed part, fluctuation in caulking conditions, and the like, when the heat pipe is connected to the base block using the caulking means, an air gap is sometimes formed in a connecting part of the recessed part of the base block and the heat pipe. From the above description, when the heat pipe is connected to the base block by the caulking means, there is room of improvement in the heat transferability from the base block to the heat pipe. With the caulking means, since the air gap is formed in the connecting part of the recessed part of the base block and the heat pipe. Therefore, there is room of improvement in the fixing stability of heat pipe to the base block.

### Document List

### Patent Literature

Patent Literature 1: Japanese Patent Application Publication No. 2001-248982
Patent Literature 2: Japanese Patent Applicatin Publication No. JP 2011-169506

### Summary of Invention

### Technical Problem

In view of the circumstances described above, an object of the present invention is to provide a heat pipe structure that is excellent in heat transferability from a base block to a heat pipe and excellent in fixing stability of the heat pipe to the base block even if the heat pipe is thermally connected to the base block using caulking means and a heat sink including the heat pipe structure.

### Solution to Problem

The invention is defined by the independent claims. Preferred embodiments are described in the dependent claims. A gist of a configuration of the present invention is as described below.

The invention relates to a heat pipe structure including:
a base block including a rear surface part thermally connectable to a heat generating body; and
a heat pipe including a heat receiving tubular portion fixed to a front surface part of the base block and disposed along an in-plane direction of the base block, wherein
the base block has a longitudinal direction and a width direction and includes a recessed part in which the heat receiving tubular portion is accommodated, and
a container part of the heat pipe is caulked and fixed in the recessed part and a first metal part containing first metal having a melting point equal to or higher than 130°C and equal to or lower than 400°C and/or a first metal alloy having a melting point equal to or higher than 130°C and equal to or lower than 400°C is formed between the recessed part and an outer surface of the container part.

The base block includes the recessed part and a pair of wall parts projecting along an outer circumferential surface of the heat receiving tubular portion from width direction both sides of the recessed part, and the container part of the heat pipe is caulked and fixed to the recessed part and the pair of wall parts.

A second metal part containing second metal having a melting point higher than 400°C and equal to or lower than 1500°C and/or a second metal alloy having a melting point higher than 400°C and equal to or lower than 1500°C is further formed between the outer surface of the container part and the first metal part. The first metal part extends from between a half on a base block side in the container part and the recessed part to between the container part and the pair of wall parts.

In some embodiments, an air gap formed between the recessed part and the second metal part is filled by the first metal part.

In some embodiments, the second metal part is a plating film formed on the outer surface of the container part.
the first metal is tin (Sn) and the first metal alloy is solder.

In some embodiments, the second metal is at least one type selected out of a group consisting of nickel (Ni) and zinc (Zn).

In some embodiments, the heat pipe includes a bent part in the longitudinal direction of the container part, and a third metal part containing solder is further formed between the first metal part formed in at least a part of the bent part and the recessed part.

The invention also relates to a heat sink including:
a base block including a rear surface part thermally connectable to a heat generating body;
a heat pipe including a heat receiving tubular portion fixed to a front surface part of the base block and disposed along an in-plane direction of the base block and a heat radiating tubular portion communicating with the heat receiving tubular portion and erected from the base block; and
a heat radiation fin fixed to the heat radiating tubular portion, wherein
the base block has a longitudinal direction and a width direction and includes a recessed part in which the heat receiving tubular portion is accommodated, and
a container part of the heat pipe is caulked and fixed in the recessed part and a first metal part containing first metal having a melting point equal to or higher than 130°C and equal to or lower than 400°C and/or a first metal alloy having a melting point equal to or higher than 130°C and equal to or lower than 400°C is formed between the recessed part and an outer surface of the container part.

In some embodiments, the base block includes the recessed part and a pair of wall parts projecting along an outer circumferential surface of the heat receiving tubular portion from width direction both sides of the recessed part, and the container part of the heat pipe is caulked and fixed to the recessed part and the pair of wall parts.

In some embodiments, a second metal part containing second metal having a melting point higher than 400°C and equal to or lower than 1500°C and/or a second metal alloy having a melting point higher than 400°C and equal to or lower than 1500°C is further formed between the outer surface of the container part and the first metal part.

The invention further relates to a manufacturing method for a heat pipe structure, including:
a base block forming step of forming, on a front surface part of a base block, a recessed part having a longitudinal direction and a width direction and forming a pair of wall parts projecting in a thickness direction of the base block from width direction both sides of the recessed part;
a caulking step of preparing a heat pipe including a heat receiving tubular portion, the heat pipe including a first plating film formed on an outer surface of a container part of the heat pipe and containing first metal having a melting point equal to or higher than 130°C and equal to or lower than 400°C and/or a first metal alloy having a melting point equal to or higher than 130°C and equal to or lower than 400°C and, in a state in which the heat receiving tubular portion is accommodated in the recessed part, caulking the pair of wall parts and fixing the heat pipe to the base block; and
a heating step of performing heating treatment of the heat pipe fixed to the base block at temperature equal to or higher than 130°C and equal to or lower than 400°C, melting the first plating film, and forming a first metal part between the recessed part and the outer surface of the container part.

In some embodiments, a second plating film containing second metal having a melting point higher than 400°C and equal to or lower than 1500°C and/or a second metal alloy having a melting point higher than 400°C and equal to or lower than 1500°C is further formed between the outer surface of the container part and the first plating film, and the second plating film forms a second metal part located between the outer surface of the container part and the first metal part.

In some embodiments, in the heating step, solder provided in at least a part of the recessed part is melted to form a third metal part.

The invention also relates to a manufacturing method for a heat sink, including:
a base block forming step of forming, on a front surface part of a base block, a recessed part having a longitudinal direction and a width direction and forming a pair of wall parts projecting in a thickness direction of the base block from width direction both sides of the recessed part;
a caulking step of preparing a heat pipe including a heat receiving tubular portion and a heat radiating tubular portion communicating with the heat receiving tubular portion, the heat pipe including a first plating film formed on an outer surface of a container part of the heat pipe and containing first metal having a melting point equal to or higher than 130°C and equal to or lower than 400°C and/or a first metal alloy having a melting point equal to or higher than 130°C and equal to or lower than 400°C and, in a state in which the heat receiving tubular portion is accommodated in the recessed part and the heat radiating tubular portion is erected from the base block, caulking the pair of wall parts and fixing the heat pipe to the base block;
a heating step of performing heating treatment of the heat pipe fixed to the base block at temperature equal to or higher than 130°C and equal to or lower than 400°C, melting the first plating film, and forming a first metal part between the recessed part and the outer surface of the container part; and
a heat radiation fin attaching step of attaching a heat radiation fin to the heat radiating tubular portion of the heat pipe fixed to the base block in a state in which the first metal part is formed.

In some embodiments, a second plating film containing second metal having a melting point higher than 400°C and equal to or lower than 1500°C and/or a second metal alloy having a melting point higher than 400°C and equal to or lower than 1500°C is further formed between the outer surface of the container part and the first plating film, and the second plating film forms a second metal part located between the outer surface of the container part and the first metal part.

In some embodiments, in the heating step, solder provided in at least a part of the recessed part is melted to form a third metal part.

In some embodiments, in an aspect of the heat pipe structure described above, since the heat receiving tubular portion of the heat pipe is caulked and fixed in the recessed part of the base block, the heat pipe is thermally connected to the base block. The first metal part is formed between the recessed part of the base block and the container part outer surface of the heat receiving tubular portion of the heat pipe. That is, the first metal part is formed in a part where the heat pipe is caulked and fixed to the base block. The first metal part is advanced into an air gap formed between the recessed part of the base block and the container part outer surface of the heat receiving tubular portion of the heat pipe.

In some embodiments, in an aspect of the heat pipe structure described above, in the part where the heat pipe is caulked and fixed to the base block, a laminated structure is formed in order of the container part outer surface of the heat receiving tubular portion of the heat pipe, the second metal part, and the first metal part.

### Effects of Invention

According to the aspect of the heat pipe structure of the present invention, since the first metal part is advanced into the air gap formed between the recessed part of the base block and the container part outer surface of the heat receiving tubular portion of the heat pipe, the gap is in a state filled by the first metal part. Therefore, even if the heat pipe is thermally connected to the base block using caulking means, it is possible to obtain the heat pipe structure excellent in heat transferability from the base block to the heat pipe in a caulking and fixing part and excellent in fixing stability of the heat pipe to the base block. Since the heat radiation fin, which is heat exchanging means, is attached to the heat pipe structure, even if the heat pipe is thermally connected to the base block using the caulking means, it is possible to obtain the heat sink excellent in heat transferability from the base block to the heat pipe in the caulking and fixing part and excellent in fixing stability of the heat pipe to the base block.

According to the aspect of the heat pipe structure of the present invention, the first metal part in an advanced state into the air gap is formed while preventing, since the melting point of the first metal or the first metal alloy forming the first metal part is equal to or higher than 130°C, melting of the first metal part due to a heat generation temperature of the heat generating body, which is a cooling target, and preventing, since the melting point is equal to or lower than 400°C, damage to the heat pipe.

Since the first metal part described above is formed, even if the bent part, fixing of which by caulking is difficult, is provided in the heat receiving tubular portion of the heat pipe, it is possible to improve the heat transferability from the base block to the heat pipe over the entire heat receiving tubular portion including the bent part because the first metal part is formed in the air gap formed between the bent part of the heat receiving tubular portion and the recessed part of the base block.

According to the aspect of the heat pipe structure of the present invention, since the laminated structure is formed in the order of the container part outer surface of the heat receiving tubular portion of the heat pipe, the second metal part, and the first metal part, it is possible to impart a further function to the container part outer surface by action of the second metal part while the air gap is filled by the first metal part.

According to the aspect of the heat pipe structure of the present invention, since the first metal is tin (Sn) and the first metal alloy is solder, the first metal part in an advanced state into the air gap is formed while surely preventing melting of the first metal part due to the heat generation temperature of the heat generating body and surely preventing damage to the heat pipe.

According to the aspect of the heat pipe structure of the present invention, since the second metal is at least one type selected out of a group consisting of nickel (Ni) and zinc (Zn), it is possible to impart electrolytic corrosion resistance to the container part outer surface.

According to the aspect of the heat pipe structure of the present invention, since the third metal part containing solder is further formed between the first metal part and the recessed part of the base block, the air gap formed between the bent part of the heat receiving tubular portion and the recessed part of the base block is surely filled by the first metal part and the third metal part. Therefore, the heat transferability from the base block to the heat pipe in the caulking and fixing part is further improved.

Since the third metal part described above is formed, even if the bent part, fixing of which by caulking is difficult, is provided in the heat receiving tubular portion of the heat pipe, it is possible to surely improve the heat transferability from the base block to the heat pipe over the entire heat receiving tubular portion because not only the first metal part but also the third metal part is formed in the air gap formed between the bent part of the heat receiving tubular portion and the recessed part of the base block.

### Brief Description of Drawings

[FIG. 1] An explanatory view of a heat sink in which a heat pipe structure according to an embodiment example of the present invention is used.
[FIG. 2] An explanatory view schematically showing a cross section of the heat pipe structure according to the embodiment example of the present invention.
[FIG. 3] A side sectional view of the heat pipe structure according to the embodiment example of the present invention.
[FIG. 4] A front sectional view of the heat pipe structure according to the embodiment example of the present invention.
[FIG. 5] An explanatory view of manufacturing the heat sink using the heat pipe structure according to the embodiment example of the present invention: a figure (a) is an explanatory view of a state in which a heat pipe is caulked and fixed to a base block, a figure (b) is an explanatory view of a state in which heating treatment is performed after the caulking and fixing and the heat pipe structure is manufactured, and a figure (c) is an explanatory view of a state in which a heat radiation fin is attached to the heat pipe structure and the heat sink is manufactured.

### Description of Embodiments

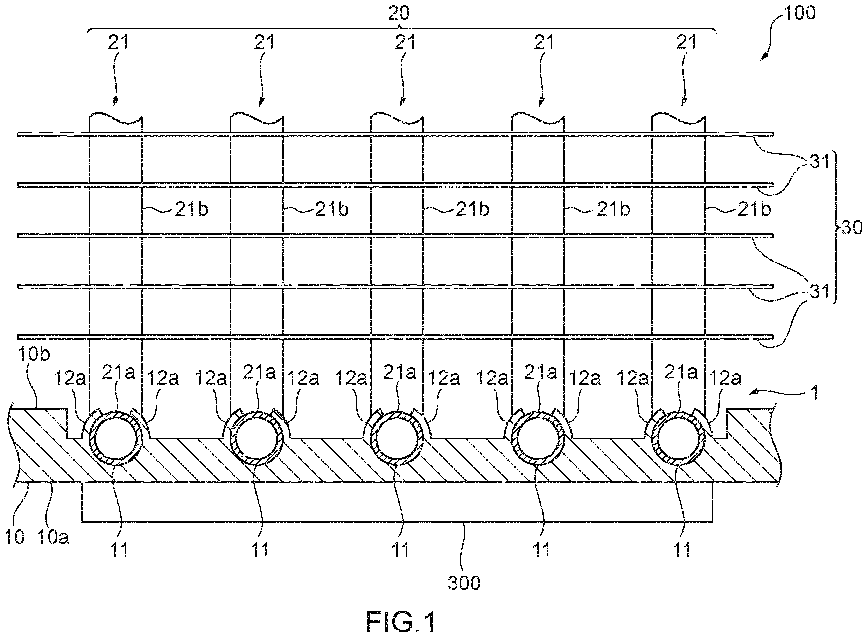

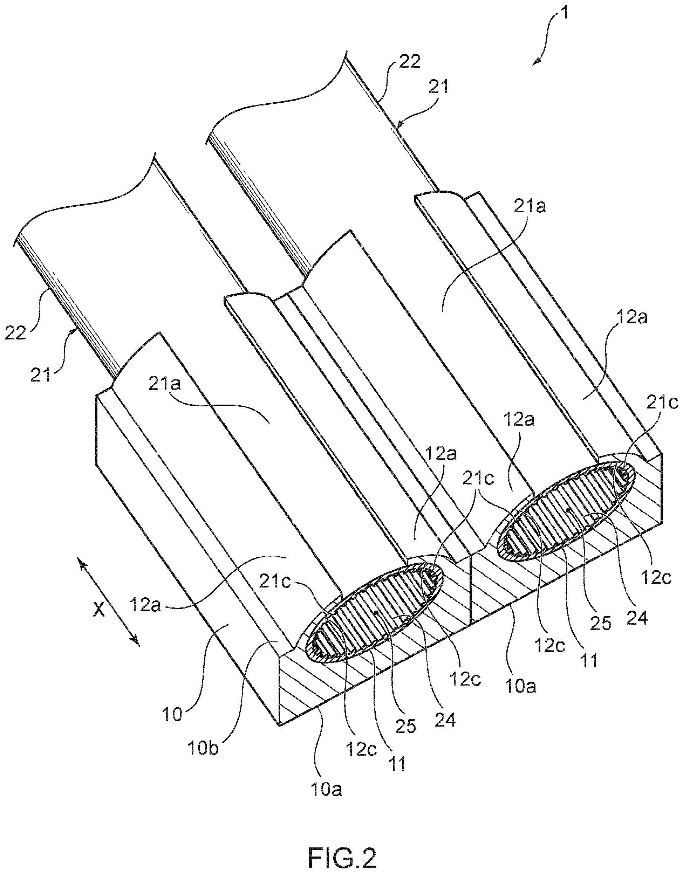

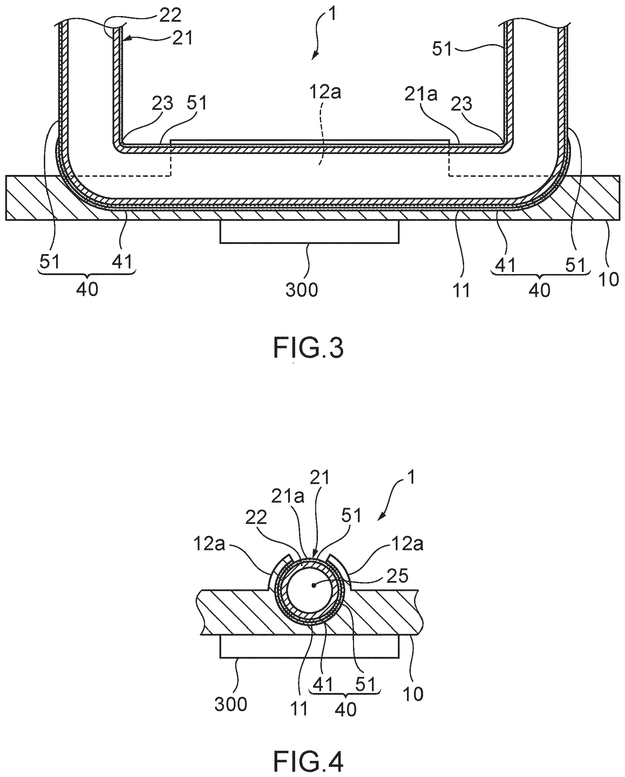

A heat pipe structure according to an embodiment example of the present invention and a heat sink in which the heat pipe structure is used are explained below with reference to the drawings. FIG. 1 is an explanatory view of the heat sink in which the heat pipe structure according to the embodiment example of the present invention is used. FIG. 2 is an explanatory view schematically showing a cross section of the heat pipe structure according to the embodiment example of the present invention. FIG. 3 is a side sectional view of the heat pipe structure according to the embodiment example of the present invention. FIG. 4 is a front sectional view of the heat pipe structure according to the embodiment example of the present invention.

First, the heat pipe structure according to the embodiment example of the present invention is explained. As shown in FIGs. 1 and 2, a heat pipe structure 1 includes a base block 10 including a rear surface part 10a thermally connectable to a heat generating body 300 and a front surface part 10b opposed to the rear surface part 10a and a heat pipe 21 including a heat receiving tubular portion 21a fixed to the front surface part 10b of the base block 10 and disposed along an in-plane direction of the base block 10.

The base block 10 has a longitudinal direction and a width direction. A shape of the base block 10 is not particularly limited. However, in the heat pipe structure 1, the base block 10 is a tabular member having predetermined thickness. A shape in a plan view of the base block 10 is a rectangular shape. The rear surface part 10a and the front surface part 10b are main surfaces of the base block 10. Note that "plan view" means a state in which the base block 10 is visually recognized from an orthogonal direction with respect to a heat transport direction in the heat receiving tubular portion 21a of the heat pipe 21 and from a direction opposed to the front surface part 10b.

The front surface part 10b of the base block 10 includes a recessed part 11, which is a strip groove in which the heat receiving tubular portion 21a of the heat pipe 21 is accommodated, and a pair of wall parts 12a, 12a projecting along an outer circumferential surface of the heat receiving tubular portion 21a from both sides in the orthogonal direction (thereafter, sometimes referred to as "width direction") with respect to the longitudinal direction of the recessed part 11. Since a container part 22 of the heat receiving tubular portion 21a is caulked and fixed to the recessed part 11 and the pair of wall parts 12a, 12a, the heat pipe 21 is caulked and fixed to the base block 10.

In the heat pipe structure 1, the recessed part 11 extends, for example, in the longitudinal direction of the base block 10 along an in-plane direction of the base block 10. A shape in the longitudinal direction of the recessed part 11 corresponds to a shape in the longitudinal direction of the heat receiving tubular portion 21a. A shape in the width direction of the recessed part 11 corresponds to a shape of a substantially lower half in a shape in the width direction of the heat receiving tubular portion 21a, that is, corresponds to a shape of a substantial half on the base block 10 side. Note that, in the heat pipe structure 1, the shape in the longitudinal direction of the heat receiving tubular portion 21a is a linear shape and a shape of a width direction cross section of the container 22 in the heat receiving tubular portion 21a is a substantially circular shape.

As shown in FIG. 2, like the recessed part 11, the pair of wall parts 12a, 12a is provided along the in-plane direction of the base block 10. For example, the wall part 12a extends along an extending direction of the recessed part 11 and extends in parallel to the extending direction of the recessed part 11. The pair of wall parts 12a, 12a projects toward an upward direction of the recessed part 11 in a width direction cross section and is bent toward a width direction center of the recessed part 11 to come close to each other. The pair of wall parts 12a, 12a is formed as a pair of ridge parts projecting along an outer circumferential surface 21c of the heat receiving tubular portion 21a opposed to the pair of wall parts 12a, 12a and extending along the longitudinal direction of the heat receiving tubular portion 21a (an X direction in FIG. 2). The pair of ridge parts respectively includes press contact surfaces 12c that are in press contact with the outer circumferential surface 21c of the heat receiving tubular portion 21a opposed to the pair of ridge parts. Since the pair of ridge parts includes a pair of press contact surfaces 12c, 12c, a contact area of the pair of ridge parts and the heat receiving tubular portion 21a increases and adhesion between the base block 10 and the heat pipe 21 is improved.

The heat pipe 21 includes the container part 22 having a tube shape, an end face at one end and an end face at another end of which are sealed, a wick structure 24 provided on an inside of the container part 22, and working fluid encapsulated in a hollow part 25, which is an internal space of the container part 22. The hollow part 25 of the container part 22 is a sealed space and is subjected to decompression treatment. A material of the container part 22 is not particularly limited. Examples of the material of the container part 22 include copper, a copper alloy, aluminum, an aluminum alloy, and stainless steel. The working fluid can be selected as appropriate according to compatibility with the material of the container part 22. Examples of the working fluid include water, alternative freon, perfluorocarbon, and cyclopentane. The wick structure 24 is not particularly limited if the wick structure 24 is a structure that generates capillarity. Examples of the wick structure 24 include a plurality of thin grooves (grooves) extending along the longitudinal direction of the container part 22, a sintered body of metal power, and a metal mesh. Note that, in FIG. 2, the groove is used as the wick structure 24 from a viewpoint of preventing an increase in circular current resistance of the working fluid in a liquid phase.

As shown in FIGs. 3 and 4, a second metal part 51 containing second metal having a melting point higher than 400°C and equal to or lower than 1500°C and/or a second meat alloy having a melting point higher than 400°C and equal to or lower than 1500°C is formed on an outer surface of the container part 22. In the heat pipe structure 1, a shape of the second metal part 51 is a layered shape. The second metal part 51 covers the outer surface of the container part 22 including the heat receiving tubular portion 21a. A further function can be imparted to the container part 22 outer surface by action of the second metal part 51. A metal type of the second metal part 51 can be selected according to a type of the further function imparted to the container 22 outer surface. Average thickness of the second metal part 51 is not particularly limited. Examples of the average thickness of the second metal part 51 include a range of 1.0 µm to 20 µm. In the heat pipe structure 1, the second metal part 51 is, for example, a plating film (a second plating film) formed on the outer surface of the container part 22. The second metal part 51 may be directly formed on the outer surface of the container part 22 or may be formed on the outer surface of the container part 22 via another layer. In the heat pipe structure 1, the second metal part 51 is directly formed on the outer surface of the container part 22.

A metal type of the second metal is not particularly limited if the melting point is higher than 400°C and equal to or lower than 1500°C. Examples of the second metal include nickel (Ni) and zinc (Zn). The second metal alloy is not particularly limited if the melting point is higher than 400°C and equal to or lower than 1500°C. Examples of the second metal alloy include a nickel (Ni) alloy, a copper (Cu) alloy, and a zinc (Zn) alloy. Since the second metal and the second metal alloy are the metal types described above, electrolytic corrosion resistance can be imparted to the container part 22. Since the electrolytic corrosion resistance is imparted to the container part 22, even if moisture adheres to the heat pipe 21, electrolytic corrosion of the container part 22 can be prevented.

The second metal part 51 only has to contain the second metal and/or the second metal alloy having the melting point higher than 400°C and equal to or lower than 1500°C. The second metal part 51 may be a member made of the second metal and/or the second metal alloy.

As shown in FIGs. 3 and 4, a first metal part 41 containing the first metal having the melting point equal to or higher than 130°C and equal to or lower than 400°C and/or the first metal alloy having the melting point equal to or higher than 130°C and equal to or lower than 400°C is formed between the recessed part 11 and the outer surface of the container part 22. The first metal part 41 is a metal material having a melting point lower than the melting point of the second metal part 51. A shape of the first metal part 41 is a layered shape. The first metal part 41 is formed between the second metal part 51 and the recessed part 11. That is, the first metal part 41 is formed between a substantial half on the base block 10 side in the container prat 22 and the recessed part 11. From the above description, a metal laminate part 40 including the first metal part 41 and the second metal part 51 is provided between the substantial half on the base block 10 side in the container part 22 and the recessed part 11. Note that the first metal part 41 only has to be provided between the substantial half on the base block 10 side in the container part 22 and the recessed part 11. As shown in FIGs. 3 and 4, the first metal part 41 extends from between the substantial half on the base block 10 side in the container part 22 and the recessed part 11 to between the container part 22 and the pair of wall parts 12a, 12a. That is, the first metal part 41 is provided not only between the container part 22 and the recessed part 11 but also between the container part 22 and the pair of wall parts 12a, 12a.

Average thickness of the first metal part 41 is not particularly limited. Examples of the average thickness of the first metal part 41 includes a range of 1.0 µm to 20 µm. In the heat pipe structure 1, as explained below, the first metal part 41 is derived from, for example, the plating film (a first plating film) formed on the outer surface of the second metal part 51, which is a second plating film. The first metal part 41 is formed directly on the outer surface of the second metal part 51 or may be formed on the outer surface of the second metal part 51 via another layer. In the heat pipe structure 1, the first metal part 41 is directly formed on the outer surface of the second metal part 51.

The melting point of the first metal and the first metal alloy is not particularly limited if the melting point is equal to or higher than 130°C and equal to or lower than 400°C. Since the melting point of the first metal and the first metal alloy is equal to or higher than 130°C and equal to or lower than 400°C, the first metal part 41 in a state advanced into an air gap formed between the recessed part 11 of the base block 10 and the heat receiving tubular portion 21a of the heat pipe 21 without damaging the heat pipe 21 while preventing the first metal part 41 from being melted by heat of the heat generating body 300 thermally connected to the base block 10. A lower limit value of the melting point of the first metal and the first metal alloy is preferably 180°C and particularly preferably 200°C from a viewpoint of surely preventing the first metal part 41 from being melted by the heat of the heat generating body 300 thermally connected to the base block 10. On the other hand, an upper limit value of the melting point of the first metal and the first metal alloy is preferably 280°C and particularly preferably 250°C from a viewpoint of surely forming the first metal part 41 in the advanced state into the air gap without damaging the heat pipe 21.

The first metal part 41 only has to contain the first metal and/or the first metal alloy having the melting point equal to or higher than 130°C and equal to or lower than 400°C. The first metal part 41 may be a member made of the first metal and/or the first metal alloy.

In the heat pipe structure 1, the first metal part 41 containing the first metal and/or the first metal alloy having the melting point equal to or higher than 130°C and equal to or lower than 400°C is advanced into the air gap formed between the recessed part 11 of the base block 10 and the heat receiving tubular portion 21a of the heat pipe 21 including bent parts 23 on the longitudinal direction both sides of the heat receiving tubular portion 21a. That is, the air gap is in a filled state by the first metal part 41. Therefore, in the heat pipe structure 1, even if the heat pipe 21 is thermally connected to the base block 10 using caulking means, the heat pipe structure 1 is excellent in heat transferability from the base block 10 to the heat pipe 21 in a caulking and fixing part. As a result, a cooling characteristic of the heat pipe structure 1 is improved. In the heat pipe structure 1, since the air gap is in the filled state by the first metal part 41, the heat pipe structure 1 is excellent in fixing stability of the heat pipe 21 to the base block 10.

Since the first metal part 41 is formed, even if the bent parts 23, fixing of which by caulking is difficult, are provided in the heat receiving tubular portion 21a of the heat pipe 21, the first metal part 41 is formed in the air gap formed between the bent parts 23 of the heat receiving tubular portion 21a and the recessed part 11 of the base block 10. Therefore, it is possible to improve heat transferability from the base block 10 to the heat pipe 21 over the entire heat receiving tubular portion 21a including the bent parts 23. As a result, the cooling characteristic of the heat pipe structure 1 is improved.

In the heat pipe structure 1, since the metal laminate part 40 formed in order of the second metal part 51 and the first metal part 41 is provided on the container part 22 outer surface of the heat receiving tubular portion 21a, a further function (in the heat pipe structure 1, electrolytic corrosion resistance) can be imparted to the container part 22 outer surface by the action of the second metal 51 while the air gap is filled by the first metal part 41.

A metal type of the first metal is not particularly limited if the melting point is equal to or higher than 130°C and equal to or lower than 400°C. Examples of the first metal include tin (Sn) from a viewpoint of forming the first metal part 41 in the advanced state into the air gap while surely preventing melting of the first metal part 41 due to heat generation of the heat generating body 300 and surely preventing damage to the heat pipe 21. A metal type of the first metal alloy is not particularly limited if the melting point is equal to or higher than 130°C and equal to or lower than 400°C. Examples of the first metal alloy include a tin (Sn) alloy and solder (for example, a tin alloy and a lead alloy) from a viewpoint of forming the first metal part 41 in the advanced state into the air gap while surely preventing melting of the first metal part 41 due to heat generation of the heat generating body 300 and surely preventing damage to the heat pipe 21.

Thereafter, an aspect in which the heat pipe structure 1 according to the embodiment example of the present invention is used as a cooling device in a form of a heat sink is explained. As shown in FIG. 1, a heat sink 100 includes the heat pipe structure 1 according to the embodiment example including the base block 10 including the rear surface part 10a thermally connected to the heat generating body 300, which is the cooling target, and the heat pipe 21 fixed to the front surface part 10b of the base block 10. The heat pipe 21 includes the heat receiving tubular portion 21a disposed along the in-plane direction of the base block 10 and a heat radiating tubular portion 21b connected to and communicating with the heat receiving tubular portion 21a and erected from the base block 10. In the heat sink 100, a heat pipe group 20 including a plurality of heat pipes 21 is formed. The heat sink 100 includes a heat radiation fin group 30 formed by a plurality of heat radiation fins 31, 31, ... fixed to the heat radiating tubular portion 21b in parallel to an erected direction of the heat pipe group 20, that is, an extending direction of the heat radiating tubular portion 21b. From the above description, the heat sink 100 has structure in which the heat radiation fins 31 are fixed to the heat radiating tubular portion 21b of the heat pipe 21 provided in the heat pipe structure 1.

The plurality of heat pipes 21, 21, ... forming the heat pipe group 20 are arranged in parallel at predetermined intervals. A shape in the longitudinal direction (a heat transport direction) of the heat pipe 21 is a linear shape, a shape having bent parts, or the like and is not particularly limited. For example, in FIG. 1, the heat pipe 21 is formed by a tubular body having a substantially U shape, which is a shape having bent parts on both sides of the heat receiving tubular portion 21a.

The heat receiving tubular portion 21a, a shape in the longitudinal direction of which is a linear shape, has a function of a heat receiving part heated by heat from the base block 10. The heat radiating tubular portion 21b has a function of a heat radiating part that emits heat transported from the heat receiving tubular portion 21a to the heat radiating tubular portion 21b. In the heat sink 100, the shape in the longitudinal direction of the heat radiating tubular portion 21b is a linear shape.

The plurality of heat radiation fins 31, 31, ... forming the heat radiation fin group 30 are provided in parallel at predetermined intervals in the extending direction of the heat radiating tubular portion 21b. For example, in the heat sink 100, the respective heat radiation fins 31 are provided in parallel such that principal planes of the plurality of heat radiation fins 31, 31, ... are substantially parallel. The heat radiation fin 31 includes a hole part corresponding to a position, a shape, and a dimension of the heat radiating tubular portion 21b of the heat pipe 21. For example, the heat radiation fin 31 is fixed to the heat pipe 21 by fitting and inserting the heat radiating tubular portion 21b into the hole part. The heat radiation fin 31 has a function of heat exchanging means for emitting heat from the heat radiating tubular portion 21b.

Thereafter, a mechanism of heat transport by the heat sink 100 in which the heat pipe structure 1 is used is explained. When the base block 10 of the heat sink 100 receives heat from the heat generating body 300 in the rear surface part 10a, the heat is transferred from the rear surface part 10a to the front surface part 10b of the base block 10. The heat transferred to the front surface part 10b is transferred from the front surface part 10b to the heat receiving tubular portion 21a of the heat pipe 21. When the heat is transferred to the heat receiving tubular portion 21a, the heat receiving tubular portion 21a functions as a heat receiving part (an evaporating part) of the heat pipe 21. The working fluid inside the heat pipe 21 changes from a liquid phase to a gas phase in the heat receiving part. The working fluid changed to the gas phase flows, inside the heat pipe 21, from the heat receiving part to a heat radiating part (a condensing part) of the heat radiating tubular portion 21b in the longitudinal direction of the heat pipe 21, whereby the heat from the heat generating body 300 is transported from the heat receiving part to the heat radiating part of the heat pipe 21. The working fluid in the gas phase changes to the liquid phase in the heat radiating part of the heat radiating tubular portion 21b in which the heat radiation fin 31, which is the heat exchanging means, is provided, whereby the heat transported from the heat receiving part to the heat radiating part of the heat pipe 21 is emitted as latent heat.

From the above description, since the heat sink 100 in which the heat radiation fin 31, which is the heat exchanging means, is attached to the heat pipe structure 1 is adopted, even if the heat pipe 21 is thermally connected to the base block 10 using the caulking means, the heat sink 100 is excellent in heat transferability from the base block 10 to the heat pipe 21 in the caulking and fixing part. As a result, a cooling characteristic of the heat sink 100 is improved. The heat sink 100 excellent in fixing stability of the heat pipe 21 to the base block 10 can be obtained.

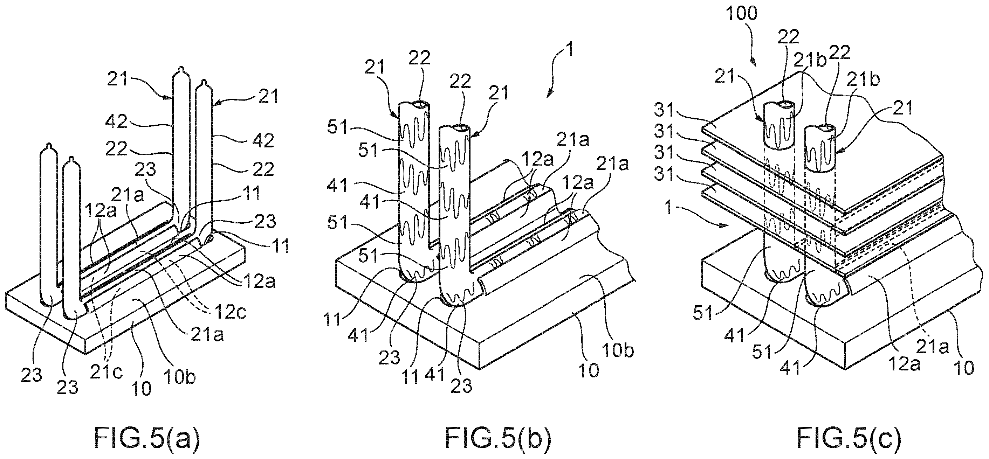

Thereafter, a manufacturing method for the heat pipe structure 1 and a manufacturing method for the heat sink 100 in which the heat pipe structure 1 is used are explained with reference to the drawings. FIG. 5 is an explanatory view of manufacturing the heat sink using the heat pipe structure according to the embodiment example of the present invention. A figure (a) is an explanatory view of a state in which the heat pipe is caulked and fixed to the base block, a figure (b) is an explanatory view of a state in which heating treatment is performed after the caulking and fixing and the heat pipe structure is manufactured, and a figure (c) is an explanatory view of a state in which the heat radiation fin is attached to the heat pipe structure and the heat sink is manufactured.

### Base block forming step

First, the recessed part 11 having the longitudinal direction and the width direction is formed in the front surface part 10b of the base block 10. The pair of wall parts 12a, 12a projecting in the thickness direction of the base block 10 from the width direction both sides of the recessed part 11 is formed. At the same time, the heat pipe 21 in which the second plating film is formed on the outer surface of the container part 22 of the heat pipe 21 and the first plating film is further formed on the second plating film is prepared. From the above description, a container of the heat pipe 21 has structure in which a laminated body 42 of a plating film including the first plating film and the second plating film is provided on the container part 22 outer surface. The laminated body 42 of the plating film may be provided over the entire outer surface of the container part 22 or may be provided in only a partial region of the container part 22 including the heat receiving tubular portion 21a. Note that, in FIG. 5, the laminated body 42 of the plating film is provided over the entire outer surface of the container part 22.

### Caulking step

In a state in which the heat receiving tubular portion 21a is accommodated in the recessed part 11, the pair of wall parts 12a, 12a is caulked to fix the heat pipe 21 including the heat receiving tubular portion 21a to the base block 10, the heat pipe 21 being the prepared heat pipe 21 including the first plating film containing the first metal having the melting point equal to or higher than 130°C and equal to or lower than 400°C and/or the first metal alloy having the melting point equal to or higher than 130°C and equal to or lower than 400°C formed on the outer surface of the container part 22 of the heat pipe 21. The heat radiating tubular portion 21b is in a state erected from the base block 10. Specifically, for example, the heat receiving tubular portion 21a of the heat pipe 21 is fit in the recessed part 11 of the base block 10 and the heat receiving tubular portion 21a is accommodated in the recessed part 11. At this time, the heat radiating tubular portion 21b is set in the state erected from the base block 10. Thereafter, a caulking part formed in a concave shape of a caulking jig (not shown in the figures) are brought into contact with distal end portions of the pair of wall parts 12a, 12a. The caulking jig is moved downward in a vertical direction (that is, a direction of the base block 10) to caulk the pair of wall parts 12a, 12a. At this time, the outer circumferential surface 21c of the heat receiving tubular portion 21a in contact with the pair of wall parts 12a, 12a receives stress on a width direction outer side from the pair of wall parts 12a, 12a. The pair of wall parts 12a, 12a is brought into press contact with the outer circumferential surface 21c of the heat receiving tubular portion 21a. When the caulking jig is further moved downward in the vertical direction to further caulk the pair of wall parts 12a, 12a, the press contact surfaces 12c on which the pair of wall parts 12a, 12a is in press contact with the outer circumferential surface 21c of the heat receiving tubular portion 21a is formed.

As shown in FIG. 5(a), when the press contact surfaces 12c are formed, the heat receiving tubular portion 21a is caulked and fixed to the pair of wall parts 12a, 12a and the recessed part 11. As a result, the heat pipe 21 is caulked and fixed to the base block 10.

### Heating step

The heat pipe 21 fixed to the base block 10 is subjected to heating treatment at temperature equal to or higher than 130°C and equal to or lower than 400°C, the first plating film is melted, and the first metal part 41 is formed between the recessed part 11 and the outer surface of the container part 22. In a heating step, since the first plating film is melted, a heating temperature in the heating step is temperature equal to or higher than the melting point of the first plating film. The heating temperature is set to be equal to or higher than 130°C and equal to or lower than 400°C according to the melting point equal to or higher than 130°C and equal to or lower than 400°C of the first metal and the first metal alloy forming the first metal part 41. For example, when the first plating film is a tin plating film, since a melting point of tin is 232°C, the heating temperature is set to be equal to or higher than 232°C and equal to or lower than 400°C. On the other hand, since the melting point of the second metal and the second metal alloy forming the second metal part 51 is higher than 400°C and equal to or lower than 1500°C, in the heating step, the second plating film, which is the second metal part 51, does not melt.

A melted object of the first metal film moves downward in a gravity direction with action of gravity. At least a part of the melted object of the first plating film intrudes into between the recessed part 11 and the second plating film (the second metal part 51) formed on the container part 22 outer surface. The first plating film located between the recessed part 11 and the second plating film (the second metal part 51) formed on the container part 22 outer surface is also melted by the heating treatment. At this time, the melted object of the first plating film intrudes into an air gap formed between the recessed part 11 of the base block 10 and the second plating film (the second metal part 51) formed on the container part 22 outer surface of the heat receiving tubular portion 21a including the bent parts 23 on both the sides of the heat receiving tubular portion 21a. The air gap is in a filled state by the melted object of the first plating film.

Thereafter, when the melted object of the first metal film is cooled, the melted object of the first metal film solidifies. The first metal part 41 containing the first metal and/or the first metal alloy having the melting point equal to or higher than 130°C and equal to or lower than 400°C is formed in an advanced state into the air gap. That is, it is possible to manufacture the heat pipe structure 1 shown in FIG. 5(b) in a state in which the air gap is filled by the first metal part 41. In the heat pipe structure 1, a region where the melted first plating film moves downward in the gravity direction and the first plating film does not remain on the container outer surface is in a state in which the second plating film forming the second metal part 51 is exposed.

### Heat radiation fin attaching step

Thereafter, as shown in FIG. 5(c), the heat radiation fin 31 is attached to the heat radiating tubular portion 21b of the heat pipe 21 fixed to the base block 10 in a state in which the first metal part 41 is formed. The heat sink 100 can be manufactured by attaching the plurality of heat radiation fins 31, 31, ... to the heat pipe structure 1 obtained as explained above.

Thereafter, another embodiment example of the heat pipe structure of the present invention is explained. In the heat pipe structure 1 according to the embodiment example explained above, the first metal part 41 is formed in at least a part between the bent parts 23 on the longitudinal direction both sides of the heat receiving tubular portion 21a and the recessed part 11. Instead of this, a third metal part containing solder may be further formed between the first metal part 41 formed at least in a part of the bent parts 23 and the recessed part 11. Examples of the solder of the third metal part include a tin alloy and a lead alloy.

Whereas an air gap is easily formed between the bent parts 23 of the heat receiving tubular portion 21a and the recessed part 11 of the base block 10, since the third metal part containing solder is further formed between the first metal part 41 located in the bent parts 23 of the heat receiving tubular portion 21a and the recessed part 11 of the base block 10, whereby the air gap formed between the bent parts 23 of the heat receiving tubular portion 21a and the recessed part 11 of the base block 10 is surely filled by the first metal part 41 and the third metal part. Therefore, the heat transferability from the base block 10 to the heat pipe 21 in the caulking and fixing part is further improved. Even if the bent parts 23, fixing of which by caulking is difficult, are provided in the heat receiving tubular portion 21a of the heat pipe 21, since not only the first metal part 41 but also the third metal part explained above is formed in the air gap between the bent parts 23 of the heat receiving tubular portion 21a and the recessed part 11 of the base block 10, it is possible to surely improve the heat transferability from the base block 10 to the heat pipe 21 over the entire longitudinal direction of the heat receiving tubular portion 21a.

Examples of a forming method for the third metal part include a method of, in the heating step explained above, melting the solder provided in at least a part of the recessed part 11 of the base block 10 and cooling the melted solder. More specifically, for example, the heat receiving tubular portion 21a is accommodated in the recessed part 11 in a state in which a predetermined amount of the solder, which is a material of the third metal part, is placed in advance in positions corresponding to the bent parts 23 of the heat receiving tubular portion 21a in the recessed part 11 of the base block 10 or a predetermined amount of the solder, which is the material of the third metal part, is supplied to the position corresponding to the bent parts 23 of the heat receiving tubular portion 21a in a state in which the heat receiving tubular portion 21a is accommodated in the recessed part 11, and the caulking step explained above is carried out. Thereafter, the third metal part can be formed by melting the solder, which is the material of the third metal part, in the heating step and cooling the melted solder. After the caulking step is carried out, the third metal part may be formed by supplying the predetermined amount of the solder, which is the material of the third metal part, to the positions corresponding to the bent parts 23 of the heat receiving tubular portion 21a in the recessed part 11 of the base block 10, melting the solder, which is the material of the third metal part, in the heating step explained above, and cooling the melted solder.

In the heat pipe structure 1 according to the embodiment example, the second metal part 51, which is the second plating film, is provided on the outer surface of the container part 22 in order to impart the further function (for example, electrolytic corrosion resistance) to the outer surface of the container part 22. However, when it is unnecessary to impart the further function to the outer surface of the container part 22, the second metal part 51 does not have to be provided.

The heat pipe structure 1 according to the embodiment example includes the laminated body 42 of the plating films having the two-layer structure in which the second plating film is directly formed on the outer surface of the container part 22 of the heat pipe 21 and the first plating film is further directly formed on the second plating film. Instead of this, a plating film provided on the outer surface of the container part 22 of the heat pipe 21 may be the laminated body 42 of plating films in three or more layers. For example, another plating film may be provided between the outer surface of the container part 22 and the second plating film. Another plating film may be provided between the second plating film and the first plating film.

### Industrial Applicability

The heat pipe structure of the present invention is usable in a broad range of fields. The heat pipe structure has a high utility value in a field of cooling heat generating bodies mounted on, for example, a personal computer, a server for data centers, and transportation machines such as a railroad and an automobile. In particular, the heat pipe structure of the present invention is excellent in fixing stability of the heat pipe to the base block and has vibration resistance. Therefore, the heat pipe structure has a high utility value in a field of, for example, the transportation machines such as a railroad and an automobile in which a vibration load is applied to the heat sink.

### List of Reference Signs

1 heat pipe structure
10 base block
11 recessed part
12a wall part
21 heat pipe
21a heat receiving tubular portion
22 container part
41 first metal part
51 second metal part
100 heat sink

## Claims

1. A heat pipe structure (1) comprising:
a base block (10) including a rear surface part (10a) thermally connectable to a heat generating body; and
a heat pipe (21) including a heat receiving tubular portion (21a) fixed to a front surface part (10b) of the base block (10) and disposed along an in-plane direction of the base block (10), wherein
the base block (10) has a longitudinal direction and a width direction and includes a recessed part (11) in which the heat receiving tubular portion (21a) is accommodated, and
a container part (22) of the heat pipe (21) is caulked and fixed in the recessed part (11) and a first metal part (41) containing first metal having a melting point equal to or higher than 130°C and equal to or lower than 400°C and/or a first metal alloy having a melting point equal to or higher than 130°C and equal to or lower than 400°C is formed between the recessed part (11) and an outer surface of the container part (22), and
the base block (10) includes the recessed part (11) and a pair of wall parts (12a) projecting along an outer circumferential surface of the heat receiving tubular portion (21a) from width direction both sides of the recessed part (11), and the container part (22) of the heat pipe (21) is caulked and fixed to the recessed part (11) and the pair of wall parts (12a), **characterised in that**
a second metal part (51) containing second metal having a melting point higher than 400°C and equal to or lower than 1500°C and/or a second metal alloy having a melting point higher than 400°C and equal to or lower than 1500°C is further formed between the outer surface of the container part (22) and the first metal part (41), and
wherein the first metal part (41) extends from between a half on a base block (10) side in the container part (22) and the recessed part (11) to between the container part (22) and the pair of wall parts (12a).

2. The heat pipe structure according to claim 1, wherein an air gap formed between the recessed part (11) and the second metal part (51) is filled by the first metal part (41).

3. The heat pipe structure according to claim 1 or 2, wherein the second metal part (51) is a plating film formed on the outer surface of the container part (22).

4. The heat pipe structure according to any one of claims 1 to 3, wherein the first metal is tin (Sn) and the first metal alloy is solder.

5. The heat pipe structure according to any one of claims 1 to 4, wherein the second metal is at least one type selected out of a group consisting of nickel (Ni) and zinc (Zn).

6. The heat pipe structure according to any one of claims 1 to 5, wherein the heat pipe (21) includes a bent part in the longitudinal direction of the container part (22), and a third metal part containing solder is further formed between the first metal part (41) formed in at least a part of the bent part and the recessed part.

7. A heat sink (100) comprising:
a heat pipe structure according to any one of claims 1 to 6,
a heat radiating tubular portion (21a) communicating with the heat receiving tubular portion (21a) and erected from the base block (10) of the heat pipe structure (1); and
a heat radiation fin (31) fixed to the heat radiating tubular portion (21b) heat pipe structure (1).

8. A manufacturing method for a heat pipe structure (1), comprising:
a base block (10) forming step of forming, on a front surface part (10b) of a base block (10), a recessed part (11) having a longitudinal direction and a width direction and forming a pair of wall parts (12a) projecting in a thickness direction of the base block (10) from width direction both sides of the recessed part (11);
a caulking step of preparing a heat pipe (21) including a heat receiving tubular portion (21a), the heat pipe (21) including a first plating film formed on an outer surface of a container part (22) of the heat pipe (21) and containing first metal having a melting point equal to or higher than 130°C and equal to or lower than 400°C and/or a first metal alloy having a melting point equal to or higher than 130°C and equal to or lower than 400°C and, in a state in which the heat receiving tubular portion (21a) is accommodated in the recessed part (11), caulking the pair of wall parts (12a) and fixing the heat pipe (21) to the base block (10); and
a heating step of performing heating treatment of the heat pipe (21) fixed to the base block (10) at temperature equal to or higher than 130°C and equal to or lower than 400°C, melting the first plating film, and forming a first metal part (41) between the recessed part (11) and the outer surface of the container part (22), and
a second plating film containing second metal having a melting point higher than 400°C and equal to or lower than 1500°C and/or a second metal alloy having a melting point higher than 400°C and equal to or lower than 1500°C is further formed between the outer surface of the container part (22) and the first plating film, and the second plating film forms a second metal part (51) located between the outer surface of the container part (22) and the first metal part (41), and
wherein the first metal part (41) extends from between a half on a base block (10) side in the container part (22) and the recessed part (11) to between the container part (22) and the pair of wall parts (12a).

9. The manufacturing method for a heat pipe structure (1) according to claim 8, wherein a melted object of the first plating film intrudes into an air gap formed between the recessed part (11) and the second plating film and the air gap is in a filled state by the melted object of the first plating film.

10. The manufacturing method for the heat pipe structure according to claim 8 or 9, wherein, in the heating step, solder provided in at least a part of the recessed part (11) is melted to form a third metal part.

11. A manufacturing method for a heat sink (100), comprising:
a base block (10) forming step of forming, on a front surface part (10b) of a base block (10), a recessed part (11) having a longitudinal direction and a width direction and forming a pair of wall parts (12a) projecting in a thickness direction of the base block (10) from width direction both sides of the recessed part (11);
a caulking step of preparing a heat pipe (21) including a heat receiving tubular portion (21a) and a heat radiating tubular portion (21b) communicating with the heat receiving tubular portion (21a), the heat pipe (21) including a first plating film formed on an outer surface of a container part (22) of the heat pipe (21) and containing first metal having a melting point equal to or higher than 130°C and equal to or lower than 400°C and/or a first metal alloy having a melting point equal to or higher than 130°C and equal to or lower than 400°C and, in a state in which the heat receiving tubular portion (21a) is accommodated in the recessed part (11) and the heat radiating tubular portion (21b) is erected from the base block (10), caulking the pair of wall parts (12a) and fixing the heat pipe (21) to the base block (10);
a heating step of performing heating treatment of the heat pipe (21) fixed to the base block (10) at temperature equal to or higher than 130°C and equal to or lower than 400°C, melting the first plating film, and forming a first metal part (41) between the recessed part (11) and the outer surface of the container part (22); and
a heat radiation fin (31) attaching step of attaching a heat radiation fin (31) to the heat radiating tubular portion (21b) of the heat pipe (21) fixed to the base block (10) in a state in which the first metal part (41) is formed, and
a second plating film containing second metal having a melting point higher than 400°C and equal to or lower than 1500°C and/or a second metal alloy having a melting point higher than 400°C and equal to or lower than 1500°C is further formed between the outer surface of the container part (22) and the first plating film, and the second plating film forms a second metal part (51) located between the outer surface of the container part (22) and the first metal part (41), and
wherein the first metal part (41) extends from between a half on a base block (10) side in the container part (22) and the recessed part (11) to between the container part (22) and the pair of wall parts (12a).

12. The manufacturing method for a heat sink (100) according to claim 11, wherein a melted object of the first plating film intrudes into an air gap formed between the recessed part (11) and the second plating film and the air gap is in a filled state by the melted object of the first plating film.

13. The manufacturing method for the heat sink according to claim 11 or 12, wherein, in the heating step, solder provided in at least a part of the recessed part (11) is melted to form a third metal part.

## Patentansprüche

1. Wärmerohrstruktur (1), umfassend:
einen Basisblock (10), der einen hinteren Oberflächenteil (10a), der thermisch mit einem wärmeerzeugenden Körper verbindbar ist, beinhaltet; und
ein Wärmerohr (21), das einen wärmeaufnehmenden röhrenförmigen Abschnitt (21a) beinhaltet, der an einem vorderen Oberflächenteil (10b) des Basisblocks (10) befestigt ist und entlang einer Richtung des Basisblocks (10) in gleicher Ebene angeordnet ist, wobei
der Basisblock (10) eine Längsrichtung und eine Breitenrichtung aufweist und einen vertieften Teil (11), in dem der wärmeaufnehmende röhrenförmige Abschnitt (21a) untergebracht ist, beinhaltet und
ein Behälterteil (22) des Wärmerohrs (21) an dem vertieften Teil (11) verstemmt und befestigt ist und ein erster Metallteil (41), der ein erstes Metall, das einen Schmelzpunkt von gleich oder höher als 130 °C und gleich oder niedriger als 400 °C aufweist, und/oder eine erste Metalllegierung, die einen Schmelzpunkt von gleich oder höher als 130 °C und gleich oder niedriger als 400 °C aufweist, enthält, zwischen dem vertieften Teil (11) und einer äußeren Oberfläche des Behälterteils (22) gebildet ist und
der Basisblock (10) den vertieften Teil (11) und ein Paar von Wandteilen (12a), die entlang einer äußeren Umfangsoberfläche des wärmeaufnehmenden röhrenförmigen Abschnitts (21a) in Breitenrichtung von beiden Seiten des vertieften Teils (11) hervorstehen, beinhaltet und der Behälterteil (22) des Wärmerohrs (21) an dem vertieften Teil (11) und dem Paar von Wandteilen (12a) verstemmt und befestigt ist, **dadurch gekennzeichnet, dass**
ein zweiter Metallteil (51), der ein zweites Metall, das einen Schmelzpunkt von höher als 400 °C und gleich oder niedriger als 1500 °C aufweist, und/oder eine zweite Metalllegierung, die einen Schmelzpunkt von höher als 400 °C und gleich oder niedriger als 1500 °C aufweist, enthält, ferner zwischen der äußeren Umfangsoberfläche des Behälterteils (22) und dem ersten Metallteil (41) gebildet ist, und
wobei sich der erste Metallteil (41) von zwischen einer Hälfte einer Seite des Basisblocks (10) in dem Behälterteil (22) und dem vertieften Teil (11) zu zwischen dem Behälterteil (22) und dem Paar von Wandteilen (12a) erstreckt.

2. Wärmerohrstruktur nach Anspruch 1, wobei eine Luftlücke, die zwischen dem vertieften Teil (11) und dem zweiten Metallteil (51) gebildet ist, durch den ersten Metallteil (41) gefüllt ist.

3. Wärmerohrstruktur nach Anspruch 1 oder 2, wobei der zweite Metallteil (51) ein Plattierungsfilm ist, der auf der äußeren Oberfläche des Behälterteils (22) gebildet ist.

4. Wärmerohrstruktur nach einem der Ansprüche 1 bis 3, wobei das erste Metall Zinn (Sn) und die erste Metalllegierung Lötmetall ist.

5. Wärmerohrstruktur nach einem der Ansprüche 1 bis 4, wobei das zweite Metall mindestens ein Typ ist, der aus einer Gruppe ausgewählt ist, die aus Nickel (Ni) und Zink (Zn) besteht.

6. Wärmerohrstruktur nach einem der Ansprüche 1 bis 5, wobei das Wärmerohr (21) einen gebogenen Teil in der Längsrichtung des Behälterteils (22) beinhaltet und ein dritter Metallteil, der das Lötmetall enthält, ferner zwischen dem ersten Metallteil (41), der in mindestens einem Teil des gebogenen Teils gebildet ist, und dem vertieften Teil gebildet ist.

7. Kühlkörper (100), umfassend:
eine Wärmerohrstruktur nach einem der Ansprüche 1 bis 6,
einen wärmeabgebenden röhrenförmigen Abschnitt (21a), der mit dem wärmeaufnehmenden röhrenförmigen Abschnitt (21a) kommuniziert und auf dem Basisblock (10) der Wärmerohrstruktur (1) errichtet ist; und
eine Wärmeabgaberippe (31), die an dem wärmeabgebenden röhrenförmigen Abschnitt (21b) der Wärmerohrstruktur (1) befestigt ist.

8. Herstellungsverfahren für eine Wärmerohrstruktur (1), umfassend:
einen Basisblock (10)-Bildungsschritt zum Bilden, auf einem vorderen Oberflächenteil (10b) eines Basisblocks (10), eines vertieften Teils (11), der eine Längsrichtung und eine Breitenrichtung aufweist, und Bilden eines Paars von Wandteilen (12a), die in einer Dickenrichtung des Basisblocks (10) in Breitenrichtung von beiden Seiten des vertieften Teils (11) vorstehen;
einen Verstemmschritt zum Vorbereiten eines Wärmerohrs (21), das einen wärmeaufnehmenden röhrenförmigen Abschnitt (21a) beinhaltet, wobei das Wärmerohr (21) einen ersten Plattierungsfilm beinhaltet, der auf einer äußeren Oberfläche eines Behälterteils (22) des Wärmerohrs (21) gebildet ist und ein erstes Metall, das einen Schmelzpunkt von gleich oder höher als 130 °C und gleich oder niedriger als 400 °C aufweist, und/oder eine erste Metalllegierung, die einen Schmelzpunkt von gleich oder höher als 130 °C und gleich oder niedriger als 400 °C aufweist, enthält, und, in einem Zustand, in dem der wärmeaufnehmende röhrenförmige Abschnitt (21a) in dem vertieften Teil (11) untergebracht ist, Verstemmen des Paars von Wandteilen (12a) und Befestigen des Wärmerohrs (21) an dem Basisblock (10); und
einen Erwärmungsschritt zum Durchführen einer Wärmebehandlung des Wärmerohrs (21), das an dem Basisblock (10) befestigt ist, bei einer Temperatur von gleich oder höher als 130 °C und gleich oder niedriger als 400 °C, Schmelzen des ersten Plattierungsfilms und Bilden eines ersten Metallteils (41) zwischen dem vertieften Teil (11) und der äußeren Oberfläche des Behälterteils (22), und
wobei ein zweiter Plattierungsfilm, der ein zweites Metall, das einen Schmelzpunkt von höher als 400 °C und gleich oder niedriger als 1500 °C aufweist, und/oder eine zweite Metalllegierung, die einen Schmelzpunkt von höher als 400 °C und gleich oder niedriger als 1500 °C aufweist, enthält, ferner zwischen der äußeren Oberfläche des Behälterteils (22) und dem ersten Plattierungsfilm gebildet wird und der zweite Plattierungsfilm einen zweiten Metallteil (51) bildet, der sich zwischen der äußeren Oberfläche des Behälterteils (22) und dem ersten Metallteil (41) befindet, und
wobei sich der erste Metallteil (41) von zwischen einer Hälfte an einer Seite des Basisblocks (10) in dem Behälterteil (22) und dem vertieften Teil (11) zu zwischen dem Behälterteil (22) und dem Paar von Wandteilen (12a) erstreckt.

9. Herstellungsverfahren für eine Wärmerohrstruktur (1) nach Anspruch 8, wobei ein geschmolzenes Objekt des ersten Plattierungsfilms in eine Luftlücke, die zwischen dem vertieften Teil (11) und dem zweiten Plattierungsfilm gebildet ist, eindringt und wobei sich die Luftlücke durch das geschmolzene Objekt des ersten Plattierungsfilms in einem gefüllten Zustand befindet.

10. Herstellungsverfahren für die Wärmerohrstruktur nach Anspruch 8 oder 9, wobei in dem Erwärmungsschritt Lötmetall, das in mindestens einem Teil des vertieften Teils (11) bereitgestellt ist, geschmolzen wird, um einen dritten Metallteil zu bilden.

11. Herstellungsverfahren für einen Kühlkörper (100), umfassend:
einen Basisblock (10)-Bildungsschritt zum Bilden, auf einem vorderen Oberflächenteil (10b) eines Basisblocks (10), eines vertieften Teils (11), der eine Längsrichtung und eine Breitenrichtung aufweist, und Bilden eines Paars von Wandteilen (12a), die in einer Dickenrichtung des Basisblocks (10) in Breitenrichtung von beiden Seiten des vertieften Teils (11) vorstehen;
einen Verstemmschritt zum Vorbereiten eines Wärmerohrs (21), das einen wärmeaufnehmenden röhrenförmigen Abschnitt (21a) und einen wärmeabgebenden röhrenförmigen Abschnitt (21b), der mit dem wärmeaufnehmenden röhrenförmigen Abschnitt (21a) kommuniziert, beinhaltet, wobei das Wärmerohr (21) einen ersten Plattierungsfilm beinhaltet, der auf einer äußeren Oberfläche eines Behälterteils (22) des Wärmerohrs (21) gebildet ist und ein erstes Metall, das einen Schmelzpunkt von gleich oder höher als 130 °C und gleich oder niedriger als 400 °C aufweist, und/oder eine erste Metalllegierung, die einen Schmelzpunkt von gleich oder höher als 130 °C und gleich oder niedriger als 400 °C aufweist, enthält, und, in einem Zustand, in dem der wärmeaufnehmende röhrenförmige Abschnitt (21a) in dem vertieften Teil (11) untergebracht ist und der wärmeabgebende röhrenförmige Abschnitt (21b) von dem Basisblock (10) errichtet ist, Verstemmen des Paars von Wandteilen (12a) und Befestigen des Wärmerohrs (21) an dem Basisblock (10);
einen Erwärmungsschritt zum Durchführen einer Wärmebehandlung des Wärmerohrs (21), das an dem Basisblock (10) befestigt ist, bei einer Temperatur von gleich oder höher als 130 °C und gleich oder niedriger als 400 °C, Schmelzen des ersten Plattierungsfilms und Bilden eines ersten Metallteils (41) zwischen dem vertieften Teil (11) und der äußeren Oberfläche des Behälterteils (22); und
einen Wärmeabgaberippe (31)-Befestigungsschritt zum Befestigen einer Wärmeabgaberippe (31) an dem wärmeabgehenden röhrenförmigen Abschnitt (21b) des Wärmerohrs (21), das an dem Basisblock (10) befestigt ist, in einem Zustand, in dem der erste Metallteil gebildet wird, und
wobei ein zweiter Plattierungsfilm, der ein zweites Metall, das einen Schmelzpunkt von höher als 400 °C und gleich oder niedriger als 1500 °C aufweist, und/oder eine zweite Metalllegierung, die einen Schmelzpunkt von höher als 400 °C und gleich oder niedriger als 1500 °C aufweist, enthält, ferner zwischen der äußeren Oberfläche des Behälterteils (22) und dem ersten Plattierungsfilm gebildet wird und der zweite Plattierungsfilm einen zweiten Metallteil (51) bildet, der sich zwischen der äußeren Oberfläche des Behälterteils (22) und dem ersten Metallteil (41) befindet, und
wobei sich der erste Metallteil (41) von zwischen einer Hälfte einer Seite des Basisblocks (10) in dem Behälterteil (22) und dem vertieften Teil (11) zu zwischen dem Behälterteil (22) und dem Paar von Wandteilen (12a) erstreckt.

12. Herstellungsverfahren für einen Kühlkörper (100) nach Anspruch 11, wobei ein geschmolzenes Objekt des ersten Plattierungsfilms in eine Luftlücke, die zwischen dem vertieften Teil (11) und dem zweiten Plattierungsfilm gebildet ist, eindringt und wobei sich die Luftlücke durch das geschmolzene Objekt des ersten Plattierungsfilms in einem gefüllten Zustand befindet.

13. Herstellungsverfahren für den Kühlkörper (100) nach Anspruch 11 oder 12, wobei in dem Erwärmungsschritt Lötmetall, das in mindestens einem Teil des vertieften Teils (11) bereitgestellt ist, geschmolzen wird, um einen dritten Metallteil zu bilden.

## Revendications

1. Structure de tube caloporteur (1) comprenant :
un bloc de base (10) incluant une partie de surface arrière (10a) pouvant être reliée thermiquement à un corps générateur de chaleur ; et
un tube caloporteur (21) incluant une portion tubulaire de réception de chaleur (21a) fixée à une partie de surface avant (10b) du bloc de base (10) et disposée le long d'une direction dans le plan du bloc de base (10), dans laquelle
le bloc de base (10) a une direction longitudinale et une direction de largeur et inclut une partie évidée (11) dans laquelle la portion tubulaire de réception de chaleur (21a) est logée, et
une partie de récipient (22) du tube caloporteur (21) est calfeutrée et fixée dans la partie évidée (11) et une première partie métallique (41) contenant un premier métal ayant un point de fusion égal ou supérieur à 130 °C et égal ou inférieur à 400 °C et/ou un premier alliage métallique ayant un point de fusion égal ou supérieur à 130 °C et égal ou inférieur à 400 °C est formée entre la partie évidée (11) et une surface extérieure de la partie de récipient (22), et
le bloc de base (10) inclut la partie évidée (11) et une paire de parties de paroi (12a) faisant saillie le long d'une surface circonférentielle extérieure de la portion tubulaire de réception de chaleur (21a) depuis la direction de largeur des deux côtés de la partie évidée (11), et la partie de récipient (22) du tube caloporteur (21) est calfeutrée et fixée à la partie évidée (11) et à la paire de parties de paroi (12a), **caractérisé en ce que**
une deuxième partie métallique (51) contenant un deuxième métal ayant un point de fusion supérieur à 400 °C et égal ou inférieur à 1500 °C et/ou un deuxième alliage métallique ayant un point de fusion supérieur à 400 °C et égal ou inférieur à 1500 °C est en outre formée entre la surface extérieure de la partie de récipient (22) et la première partie métallique (41), et
dans laquelle la première partie métallique (41) s'étend d'entre une moitié sur un côté de bloc de base (10) dans la partie de récipient (22) et la partie évidée (11) jusqu'entre la partie de récipient (22) et la paire de parties de paroi (12a).

2. Structure de tube caloporteur selon la revendication 1, dans laquelle un espace d'air formé entre la partie évidée (11) et la deuxième partie métallique (51) est rempli par la première partie métallique (41).

3. Structure de tube caloporteur selon la revendication 1 ou 2, dans laquelle la deuxième partie métallique (51) est un film de placage formé sur la surface extérieure de la partie de récipient (22).

4. Structure de tube caloporteur selon l'une quelconque des revendications 1 à 3, dans laquelle le premier métal est l'étain (Sn) et le premier alliage métallique est la soudure.

5. Structure de tube caloporteur selon l'une quelconque des revendications 1 à 4, dans laquelle le deuxième métal est au moins un type choisi dans un groupe constitué de nickel (Ni) et de zinc (Zn).

6. Structure de tube caloporteur selon l'une quelconque des revendications 1 à 5, dans laquelle le tube caloporteur (21) inclut une partie courbée dans la direction longitudinale de la partie de récipient (22), et une troisième partie métallique contenant de la soudure est en outre formée entre la première partie métallique (41) formée dans au moins une partie de la partie courbée et la partie évidée.

7. Dissipateur thermique (100) comprenant :
une structure de tube caloporteur selon l'une quelconque des revendications 1 à 6,
une portion tubulaire de rayonnement thermique (21a) en communication avec la portion tubulaire de réception thermique (21a) et érigée à partir du bloc de base (10) de la structure de tube caloporteur (1) ; et
une ailette de rayonnement thermique (31) fixée à la portion tubulaire de rayonnement thermique (21b) de la structure de tube caloporteur (1).

8. Procédé de fabrication d'une structure de tube caloporteur (1), comprenant :
une étape de formation d'un bloc de base (10) consistant à former, sur une partie de surface avant (10b) d'un bloc de base (10), une partie évidée (11) ayant une direction longitudinale et une direction de largeur et à former une paire de parties de paroi (12a) faisant saillie dans une direction d'épaisseur du bloc de base (10) à partir de la direction de largeur des deux côtés de la partie évidée (11) ;
une étape de calfeutrage consistant à préparer un tube caloporteur (21) incluant une portion tubulaire de réception de chaleur (21a), le tube caloporteur (21) incluant un premier film de placage formé sur une surface extérieure d'une partie de récipient (22) du tube caloporteur (21) et contenant un premier métal ayant un point de fusion égal ou supérieur à 130 °C et égal ou inférieur à 400 °C et/ou un premier alliage métallique ayant un point de fusion égal ou supérieur à 130 °C et égal ou inférieur à 400 °C et, dans un état dans lequel la portion tubulaire de réception de chaleur (21a) est logée dans la partie évidée (11), consistant à calfeutrer la paire de parties de paroi (12a) et à fixer le tube caloporteur (21) au bloc de base (10) ;
et une étape de chauffage consistant à effectuer un traitement de chauffage du tube caloporteur (21) fixé au bloc de base (10) à une température égale ou supérieure à 130 °C et égale ou inférieure à 400 °C, à faire fondre le premier film de placage et à former une première partie métallique (41) entre la partie évidée (11) et la surface extérieure de la partie de récipient (22), et
un deuxième film de placage contenant un deuxième métal ayant un point de fusion supérieur à 400 °C et égal ou inférieur à 1500 °C et/ou un deuxième alliage métallique ayant un point de fusion supérieur à 400 °C et égal ou inférieur à 1500 °C est en outre formé entre la surface extérieure de la partie de récipient (22) et le premier film de placage, et le deuxième film de placage forme une deuxième partie métallique (51) située entre la surface extérieure de la partie de récipient (22) et la première partie métallique (41), et
dans lequel la première partie métallique (41) s'étend d'entre une moitié sur un côté de bloc de base (10) dans la partie de récipient (22) et la partie évidée (11) jusqu'à entre la partie de récipient (22) et la paire de parties de paroi (12a).

9. Procédé de fabrication d'une structure de tube caloporteur (1) selon la revendication 8, dans lequel un objet fondu du premier film de placage pénètre dans un espace d'air formé entre la partie évidée (11) et le deuxième film de placage et l'espace d'air est dans un état rempli par l'objet fondu du premier film de placage.

10. Procédé de fabrication de la structure de tube caloporteur selon la revendication 8 ou 9, dans lequel, dans l'étape de chauffage, la brasure prévue dans au moins une partie de la partie en creux (11) est fondue pour former une troisième partie métallique.

11. Procédé de fabrication d'un dissipateur thermique (100), comprenant :
une étape de formation d'un bloc de base (10) consistant à former, sur une partie de surface avant (10b) d'un bloc de base (10), une partie évidée (11) ayant une direction longitudinale et une direction de largeur et à former une paire de parties de paroi (12a) faisant saillie dans une direction d'épaisseur du bloc de base (10) à partir de la direction de largeur des deux côtés de la partie évidée (11) ;
une étape de calfeutrage consistant à préparer un tube caloporteur (21) incluant une portion tubulaire de réception de chaleur (21a) et une portion tubulaire de rayonnement de chaleur (21b) en communication avec la portion tubulaire de réception de chaleur (21a), le tube caloporteur (21) incluant un premier film de placage formé sur une surface extérieure d'une partie de récipient (22) du tube caloporteur (21) et contenant un premier métal ayant un point de fusion égal ou supérieur à 130 °C et égal ou inférieur à 400 °C et/ou un premier alliage métallique ayant un point de fusion égal ou supérieur à 130 °C et égal ou inférieur à 400 °C et, dans un état dans lequel la portion tubulaire de réception de chaleur (21a) est logée dans la partie évidée (11) et la portion tubulaire de rayonnement de chaleur (21b) est érigée à partir du bloc de base (10), consistant à calfeutrer la paire de parties de paroi (12a) et à fixer le tube caloporteur (21) au bloc de base (10) ;
une étape de chauffage consistant à effectuer un traitement thermique du tube caloporteur (21) fixé au bloc de base (10) à une température égale ou supérieure à 130 °C et égale ou inférieure à 400 °C, à faire fondre le premier film de placage et à former une première partie métallique (41) entre la partie évidée (11) et la surface extérieure de la partie de récipient (22), et
une étape de fixation d'ailette de rayonnement thermique (31) consistant à fixer une ailette de rayonnement thermique (31) à la portion tubulaire de rayonnement thermique (21b) du tube caloporteur (21) fixé au bloc de base (10) dans un état dans lequel la première partie métallique (41) est formée, et
un deuxième film de placage contenant un deuxième métal ayant un point de fusion supérieur à 400 °C et égal ou inférieur à 1500 °C et/ou un deuxième alliage métallique ayant un point de fusion supérieur à 400 °C et égal ou inférieur à 1500 °C est en outre formé entre la surface extérieure de la partie de récipient (22) et le premier film de placage et le deuxième film de placage forme une deuxième partie métallique (51) située entre la surface extérieure de la partie de récipient (22) et la première partie métallique (41), et
dans lequel la première partie métallique (41) s'étend d'entre une moitié sur un côté du bloc de base (10) dans la partie de récipient (22) et la partie évidée (11) jusqu'entre la partie de récipient (22) et la paire de parties de paroi (12a).

12. Procédé de fabrication d'un dissipateur thermique (100) selon la revendication 11, dans lequel un objet fondu du premier film de placage pénètre dans un espace d'air formé entre la partie évidée (11) et le deuxième film de placage et l'espace d'air est dans un état rempli par l'objet fondu du premier film de placage.

13. Procédé de fabrication du dissipateur thermique selon (100) la revendication 11 ou 12, dans lequel, dans l'étape de chauffage, la soudure fournie dans au moins une partie de la partie évidée (11) est fondue pour former une troisième partie métallique.
